(19) Europäisches Patentamt
European Patent Office
Office européen des brevets

(11) **EP 4 050 642 B1**

(12) **FASCICULE DE BREVET EUROPEEN**

(45) Date de publication et mention
de la délivrance du brevet:
**04.09.2024 Bulletin 2024/36**

(21) Numéro de dépôt: **22158669.6**

(22) Date de dépôt: **24.02.2022**

(51) Classification Internationale des Brevets (IPC):
**H01L 21/311** $^{(2006.01)}$

(52) Classification Coopérative des Brevets (CPC):
**H01L 21/31111; H01L 21/31116**

(54) **PROCÉDÉ DE FORMATION DES ESPACEURS D'UNE GRILLE D'UN TRANSISTOR**

VERFAHREN ZUR BILDUNG VON ABSTANDHALTERN EINES GATES EINES TRANSISTORS

METHOD FOR FORMING SPACERS OF A TRANSISTOR GATE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **25.02.2021 FR 2101864**

(43) Date de publication de la demande:
**31.08.2022 Bulletin 2022/35**

(73) Titulaire: **Commissariat à l'énergie atomique
et aux énergies alternatives
75015 Paris (FR)**

(72) Inventeurs:
• **BACQUIE, Valentin
38054 GRENOBLE Cedex 09 (FR)**
• **POSSEME, Nicolas
38054 GRENOBLE Cedex 09 (FR)**

(74) Mandataire: **Hautier IP
20, rue de la Liberté
06000 Nice (FR)**

(56) Documents cités:
**EP-A1- 3 671 857     EP-B1- 2 939 262
EP-B1- 3 107 125**

## Description

### DOMAINE TECHNIQUE

La présente invention concerne en général les transistors à effet de champs (FET) utilisés par l'industrie de la microélectronique et plus particulièrement la réalisation des espaceurs de grille des transistors de type métal-oxyde-semiconducteur (MOSFET) majoritairement utilisés pour la production de toutes sortes de circuits intégrés.

### ETAT DE LA TECHNIQUE

La technologie CMOS (de l'anglais « Complementary Metal Oxide Semiconductor »), basée sur l'utilisation de transistors MOSFET complémentaires de type n et de type p, utilise couramment des substrats de type SOI (de l'anglais « silicon on insulator ») pour accroître les performances des transistors.

Un substrat SOI, qui comprend une fine couche superficielle de silicium monocristallin dite topSi reposant sur une couche d'oxyde de silicium enterrée dite BOX (acronyme de l'anglais « buried oxide layer »), permet notamment de réduire drastiquement les capacités parasites des transistors.

Pour améliorer encore les performances des transistors, il est avantageux que le canal du transistor dans le topSi puisse être complètement déserté de porteurs, c'est-à-dire « fully depleted » (FD), selon le vocable anglais dédié. Pour y parvenir, il est généralement nécessaire que le topSi soit très mince, typiquement d'épaisseur inférieure à 10 nm. Ce type de substrat est ainsi désigné par l'acronyme FDSOI.

Une telle épaisseur rend certaines étapes de fabrication des transistors critiques, notamment la formation des espaceurs sur les flancs latéraux de la grille des transistors.

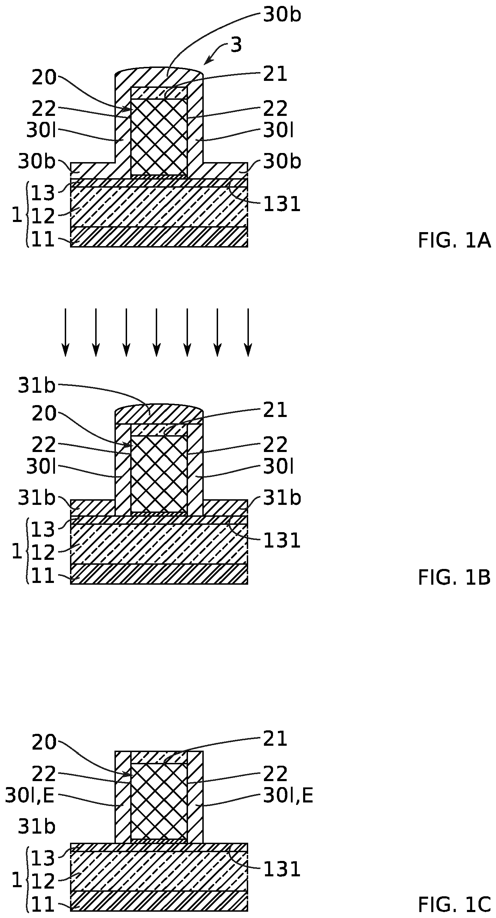

Comme illustré aux figures 1A, 1C, les espaceurs sont en effet typiquement formés par gravure anisotrope d'une couche diélectrique 3 recouvrant les grilles 20 des transistors. Cette gravure permet de graver des portions basales 30b de la couche diélectrique 3, qui s'étendent principalement de façon parallèle au plan de base du substrat 1, tout en conservant des portions latérales 30l de la couche diélectrique 3 qui s'étendent sur les flancs 22 latéraux de la grille 20. Ces dernières forment ainsi les espaceurs E de grille des transistors.

La gravure anisotrope doit ainsi permettre de retirer les portions basales 30b en exposant le topSi 13, sans endommager le topSi 13 et en conservant les portions latérales 30l.

L'arrêt de la gravure à l'interface 131 entre la couche diélectrique 3 et le topSi 13 est une problématique majeure de la formation des espaceurs.

Si la gravure est prolongée trop longtemps, le topSi peut être en partie consommé ou endommagé. Au contraire, si elle n'est pas suffisamment prolongée, les espaceurs peuvent présenter des pieds de gravure préjudiciables à la définition précise des dimensions critiques des espaceurs.

Pour éviter un compromis difficile à trouver entre ces deux conditions antagonistes lors de la gravure des portions basales 30b par implantation d'ions légers (figure 1B), suivie d'une étape de retrait des portions basales modifiées 31b, sélectivement aux portions latérales non modifiées 30l (figure 1C). Cela permet de relâcher les contraintes sur l'arrêt de gravure. La précision de gravure est ainsi améliorée.

Les documents EP671857 et EP3107125 décrivent des procédés de formation similaires.

En pratique cependant, une telle solution ne s'avère pas optimale. La précision de gravure reste perfectible. Les performances des transistors peuvent encore être améliorées.

Un objet de la présente invention est de pallier les limitations des solutions connues.

Un autre objet de la présente invention est de proposer un procédé de fabrication d'espaceurs permettant un meilleur contrôle de l'arrêt de gravure à l'interface entre la couche diélectrique et le topSi.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un procédé de formation des espaceurs d'une grille d'un transistor située sur une couche active en un matériau semi-conducteur. Le procédé comprend :

- une fourniture d'un empilement comprenant la couche active et la grille, ladite grille présentant un sommet et des flancs latéraux,
- une formation d'une couche diélectrique en un matériau diélectrique recouvrant la grille et au moins partiellement la couche active de part et d'autre de la grille, ladite couche diélectrique présentant des portions latérales recouvrant les flancs latéraux de la grille, et des portions basales recouvrant le sommet et la couche active, les portions basales présentant une épaisseur eb,
- une modification anisotrope des portions basales de ladite couche diélectrique par implantation d'ions légers selon une direction Z parallèle aux flancs latéraux de la grille, formant des portions basales modifiées à base du matériau diélectrique modifié et des portions latérales non modifiées à base du matériau diélectrique non modifié,
- un retrait des portions basales modifiées par gravure sélective du matériau diélectrique modifié vis-à-vis du matériau diélectrique non modifié et vis-à-vis du matériau semi-conducteur, de façon à former les espaceurs sur les flancs latéraux de la grille à partir des portions latérales non modifiées.

Avantageusement, avant le retrait, la modification anisotrope des portions basales comprend n phases d'implantation successives présentant des énergies d'implantation $\Gamma i$ (i=1... n) des ions légers distinctes les unes des autres, n ≥ 3, lesdites n phases étant configurées pour implanter les ions légers à différentes profondeurs nominales d'implantation dpi (i=1... n) dans les portions basales.

Chaque phase d'implantation est effectuée à partir d'un plasma, par exemple au sein d'un réacteur plasma à couplage capacitif (CCP) ou d'un réacteur plasma à couplage inductif (ICP), ou par immersion dans le plasma.

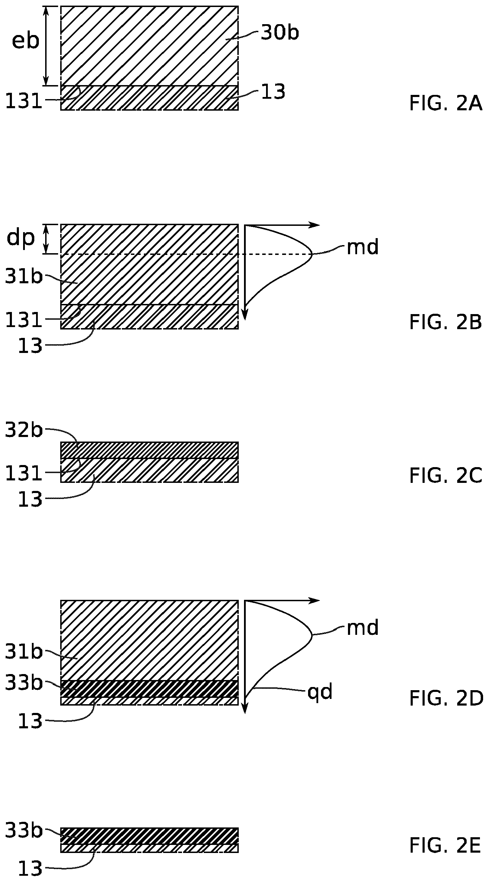

La mise en oeuvre d'un plasma pour réaliser chaque implantation est intrinsèquement très différente d'une implantation réalisée au sein d'un implanteur d'ions. Les caractéristiques d'un procédé mis en oeuvre par plasma ne peuvent pas être transposées de façon triviale à un procédé mis en oeuvre via un implanteur, et inversement. La présente invention concerne uniquement le domaine spécifique de l'implantation par plasma. Dans le cadre du développement de la présente invention, il a été observé qu'une unique implantation par plasma d'ions légers telle que divulguée par les solutions connues conduisait soit à une première situation illustrée aux figures 2A, 2B, 2C, soit à une deuxième situation illustrée aux figures 2A, 2D, 2E. Dans la première situation, la portion basale 30b présente une épaisseur eb (figure 2A) et l'implantation est configurée pour implanter des ions légers sur toute l'épaisseur eb. Il apparaît que le profil d'implantation des ions légers dans la portion basale modifiée 31b présente un maximum md à une profondeur d'implantation dp, et une queue de distribution qd située au-dessus de l'interface 131(figure 2B). La portion basale modifiée 31b présente ainsi une concentration maximale en ions légers à la profondeur dp, qui décroît ensuite en s'approchant de l'interface 131 avec la couche active 13 sous-jacente. La concentration en ions légers devient alors trop faible au voisinage de l'interface 131, de sorte qu'une partie 32b de portion basale modifiée n'est pas gravée lors de la gravure sélective du matériau diélectrique modifié vis-à-vis du matériau diélectrique non modifié (figure 2C).

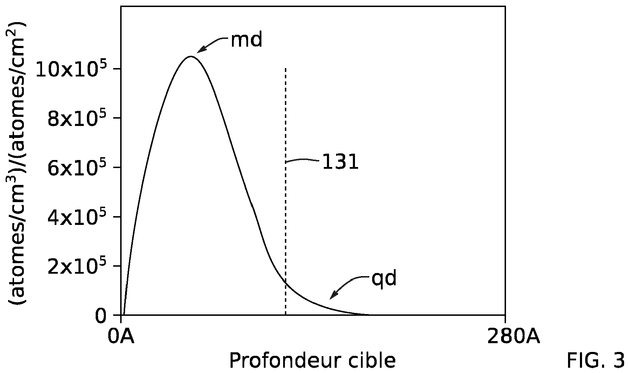

Dans la deuxième situation, l'implantation est configurée pour implanter des ions légers sur une profondeur supérieure à l'épaisseur eb. Le maximum md se déplace en direction de l'interface 131 et la queue de distribution qd du profil d'implantation est ici située en-dessous de l'interface 131 (figure 2D et figure 3). La concentration en ions légers devient suffisante sur toute l'épaisseur eb, de sorte que toute la portion basale modifiée 31b est retirée lors de la gravure sélective du matériau diélectrique modifié vis-à-vis du matériau diélectrique non modifié (figure 2E). Une telle implantation est cependant préjudiciable à la couche active 13 sous-jacente. Une partie 33b de couche active 13 située sous l'interface 131 présente dès lors une concentration en ions légers significative, provenant de la queue de distribution qd du profil d'implantation. Cela nuit aux propriétés structurelles et/ou électriques de la couche active 13.

Contrairement aux solutions connues qui prônent une modification par une unique implantation immédiatement suivie par un retrait des portions basales modifiées, le procédé selon l'invention prévoit une série de phases d'implantation successives à différentes énergies d'implantation pour modifier les portions basales le long de l'épaisseur eb, préalablement au retrait desdites portions basales modifiées.

Une telle série de phases d'implantation permet de mieux contrôler la queue de distribution des ions légers dans l'épaisseur des portions basales, avant retrait. Cela permet d'améliorer la distribution des ions légers le long de l'épaisseur eb des portions basales. La variation de concentration en ions légers le long de l'épaisseur des portions basales peut être avantageusement diminuée. Idéalement, les profondeurs nominales d'implantation des ions légers sont choisies de manière à obtenir une distribution régulière des ions légers le long de l'épaisseur eb des portions basales.

Cela peut notamment permettre d'obtenir un profil de concentration en ions légers plus constant le long de l'épaisseur eb, et plus abrupte à l'interface entre les portions basales modifiées et la couche active. La modification du matériau diélectrique est donc plus homogène selon l'épaisseur eb, et impacte moins la couche active sous-jacente. Une concentration relativement homogène ou constante d'ions légers permet d'obtenir une vitesse de gravure sensiblement constante lors du retrait. Le retrait par gravure des portions basales modifiées est ainsi mieux contrôlé. L'arrêt de la gravure au niveau de l'interface est facilité.
La couche active est préservée.

La série de phases d'implantations successives comprend typiquement au moins une phase d'implantation dite « basse énergie », par exemple à une énergie d'implantation inférieure ou égale à 50 eV, au moins une phase d'implantation dite « haute énergie », par exemple à une énergie d'implantation supérieure ou égale à 200 eV, et au moins une phase d'implantation dite « intermédiaire », par exemple à une énergie d'implantation comprise entre 50 eV et 200 eV. Le profil d'implantation d'ions légers est ainsi lissé le long de l'épaisseur eb des portions basales.

Ce procédé permet typiquement de réaliser des espaceurs sans pied et sans endommager la couche active sous-jacente.

## BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

Les figures 1A à 1C illustrent schématiquement des étapes d'un procédé de formation d'espaceurs selon l'art antérieur.

Les figures 2A à 2E illustrent schématiquement différentes problématiques relatives au procédé de formation d'espaceurs selon l'art antérieur.

La figure 3 illustre la distribution des ions légers selon un profil d'implantation de l'art antérieur.

Les figures 4A à 4E illustrent schématiquement des étapes d'un procédé de formation d'espaceurs selon un mode de réalisation de la présente invention.

Les figures 5A à 5D illustrent schématiquement des phases d'implantation d'un procédé de formation d'espaceurs selon un mode de réalisation de la présente invention.

La figure 6A illustre la distribution des ions légers selon un profil d'implantation d'un mode de réalisation de la présente invention.

La figure 7A illustre des simulations de phases d'implantation des ions légers selon un mode de réalisation de la présente invention.

La figure 7B illustre des simulations de phases d'implantation des ions légers selon un autre mode de réalisation de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches et portions, et les dimensions des motifs ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, les n phases d'implantation successives sont configurées pour modifier les portions basales selon toute l'épaisseur eb et de préférence, sans modifier structurellement la couche active. La concentration en ions légers dans la couche active reste significativement inférieure à celle résultant d'une implantation unique par plasma. La couche active est préservée.

Selon un exemple, les n phases d'implantation sont configurées de sorte à ce que les portions basales modifiées présentent après modification une variation de concentration totale en ions légers [H]tot inférieure à 20% le long de l'épaisseur eb.

Selon un exemple, le nombre de phases d'implantations n est égal à 3 et les énergies d'implantation

$\Gamma 1$, $\Gamma 2$, $\Gamma 3$ sont telles que $\Gamma 1 \leq 0{,}5.\Gamma 2$ et $\Gamma 2 \leq 0{,}6.\Gamma 3$.

Selon un exemple, chaque phase d'implantation est configurée pour implanter des ions légers à une concentration $[H]i(dpi)$ maximale à la profondeur nominale d'implantation dpi.

Selon un exemple, les profondeurs nominales d'implantation sont choisies telles que $dpi = eb.i/(i+1)$. Cela permet d'implanter une dose suffisante d'ions légers à différentes profondeurs pour assurer une bonne sélectivité de gravure lors du retrait. Les portions basales peuvent être gravées sur toute leur épaisseur.

Selon un exemple, l'implantation anisotrope est effectuée par immersion dans un plasma à base d'espèces formant les ions légers

Selon un exemple, les ions légers sont des ions à base d'hydrogène (H).

Selon un exemple, l'implantation anisotrope est effectuée par plasma à base d'espèces formant les ions légers, dans un réacteur plasma à couplage capacitif.

Selon un exemple, l'implantation anisotrope est effectuée par plasma à base d'espèces formant les ions légers, dans un réacteur plasma à couplage inductif.

Selon un exemple, le plasma est formé à partir de dihydrogène (H2) et d'au moins une espèce X favorisant la dissociation du dihydrogène pour former lesdits ions légers, ladite au moins une espèce X étant prise parmi l'argon, l'azote, le xénon, l'hélium.

Selon un exemple, chaque énergie d'implantation ti (i=1... n) est maintenue durant une durée $ti \geq 5$ s, de sorte à ce que les phases d'implantation successives forment des paliers de durée ti et d'énergie d'implantation $\Gamma i$ (i=1... n).

Selon un exemple, les énergies d'implantation $\Gamma i$ (i=1... n) sont telles que $\Gamma i+1 = \Gamma i + \Delta$, avec $\Delta$ un pas en énergie tel que $\Delta \geq 30$ eV, de préférence $\Delta \geq 50$ eV.

Selon un exemple, les n phases d'implantations sont configurées pour durer chacune une durée ti (i=1... n) $\geq T/2(n+1)$, où T est une durée totale de la modification.

Selon un exemple, les énergies d'implantation $\Gamma i$ (i=1... n) varient de façon continue et monotone entre $\Gamma 1$ et $\Gamma n$ lors de la modification anisotrope.

Selon un exemple, les énergies d'implantation $\Gamma i$ (i=1...n) sont comprises entre 20 eV et 300 eV.

Selon un exemple, les phases d'implantation sont effectuées par ordre d'énergie d'implantation croissant.

Selon un exemple, les phases d'implantation successives présentent une variation d'énergie d'implantation supérieure ou égale à 20%, tel que $0{,}8.\Gamma i-1 \leq \Gamma i \leq 1{,}2.\Gamma i+1$ avec i=1... n.

Selon un exemple, le nombre de phases d'implantations n est égal à 6 et les énergies d'implantation sont telles que $\Gamma 1 = 50$eV, $\Gamma 2 = 100$eV, $\Gamma 3 = 150$eV, $\Gamma 4 = 200$eV, $\Gamma 5 = 250$eV, $\Gamma 6 = 300$eV, chaque phase d'implantation étant effectuée pendant une durée ti (i=1...6) comprise entre 2s et 20s.

Selon un exemple, les ions légers sont pris parmi H+, H2+, H3+.

Selon un exemple, la grille est un motif de grille sacrificielle utilisé dans un procédé dit « gate last », où le motif de grille sacrificielle est remplacé par une grille fonctionnelle après formation des espaceurs.

Selon un exemple, l'énergie d'implantation varie de façon continue d'une phase d'implantation à une autre.

Selon un exemple, l'énergie d'implantation ne varie pas de façon continue d'une phase d'implantation à une autre. Elle prend des valeurs discrètes pour chaque phase d'implantation.

Selon un exemple, le transistor est un transistor de type FDSOI. De préférence, le procédé comprend après retrait des portions basales de part et d'autre de la grille, une étape de formation de zones de source et drain surélevés à partir de la couche active en un matériau semi-conducteur, par exemple par épitaxie.

Avantageusement, le matériau semi-conducteur est du silicium. Avantageusement, la gravure est sélective à l'oxyde de silicium (SiO2). Le matériau semi-conducteur peut également être du germanium (Ge) ou du silicium-germanium SiGe. L'étape de retrait de la couche diélectrique modifiée peut être effectuée par gravure humide sélectivement au Ge ou au SiGe ou et/ou à de l'oxyde de SiGe ou de l'oxyde de Ge.

Selon un exemple, la nature des ions légers et la dose totale d'ions légers implantés lors des phases d'implantation successives sont configurées de sorte que le matériau diélectrique modifié puisse être gravé de manière sélective vis-à-vis du matériau diélectrique non modifié.

Avantageusement, la modification de la couche diélectrique de nitrure de silicium par implantation d'hydrogène (H2) permet d'améliorer la sélectivité de gravure de cette couche modifiée par rapport au silicium et/ou à l'oxyde de silicium.

Selon un exemple, le matériau diélectrique est pris parmi : le SiN, le Si3N4, le SiCO, le SiC, le SiCN, le SiOCN, le SiCBN, le SiOCH.

Avantageusement, le retrait des portions basales modifiées se fait par gravure sélective du matériau diélectrique modifié vis-à-vis du matériau diélectrique non modifié et vis-à-vis du matériau semi-conducteur.

Selon un mode de réalisation, la gravure sélective du matériau diélectrique modifié est une gravure humide à l'aide d'une solution à base d'acide fluorhydrique (HF) ou à l'aide d'une solution à base d'acide phosphorique (H3PO4).

Selon un autre mode de réalisation, la gravure sélective du matériau diélectrique modifié est une gravure sèche, de préférence effectuée dans un plasma formé à partir de trifluorure d'azote (NF3) et d'ammoniac (NH3). La gravure sèche peut typiquement former des sels solides. Elle est alors suivie d'une étape de sublimation de ces sels solides.

Selon un mode de réalisation, la gravure sélective du matériau diélectrique modifié comprend :

- une gravure sèche réalisée par mise en présence des portions basales modifiées avec un mélange gazeux, de préférence uniquement gazeux, comprenant au moins un premier composant à base d'acide fluorhydrique (HF), l'acide fluorhydrique transformant en résidus non-volatiles à température ambiante lesdites portions basales modifiées,
- après la gravure sèche, un retrait des résidus non-volatiles à température ambiante par un nettoyage humide ou par un recuit thermique de sublimation.

De préférence, le retrait des portions basales modifiées est effectué à l'aide d'une solution à base d'acide phosphorique (H3PO4) ou à l'aide d'une solution à base d'acide fluorhydrique (HF).

Sauf incompatibilité, il est entendu que l'ensemble des caractéristiques optionnelles ci-dessus peuvent être combinées de façon à former un mode de réalisation qui n'est pas nécessairement illustré ou décrit. Un tel mode de réalisation n'est évidemment pas exclu de l'invention.

On entend par « ions légers » des ions provenant d'atome ou de molécule dont le numéro atomique dans la classification périodique des éléments est faible. D'une façon générale tous les éléments que l'on peut implanter dans le matériau à graver, sans provoquer de dislocation de sa structure atomique telle qu'elle entraînerait une pulvérisation de ce dernier, et donc sans re-dépôt du matériau gravé sur les parois du réacteur ou les motifs en cours de gravure eux-mêmes, sont susceptibles de convenir. De préférence, les ions légers sont à base d'hydrogène (H) ou de dihydrogène (H2) voire d'hélium (He).

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

Dans la présente invention, les portions latérales non modifiées peuvent comprendre superficiellement une faible concentration d'ions légers, dans la mesure où il existe toujours en pratique une faible déflexion des ions vis-à-vis de la direction d'implantation ciblée. Cette faible concentration n'est typiquement pas suffisante pour modifier « suffisamment » le matériau diélectrique, c'est-à-dire de sorte à ce qu'il puisse être gravé ensuite. En outre, cette couche superficielle des portions latérales est généralement de très faible épaisseur, par exemple au moins 10 fois inférieure à l'épaisseur des portions latérales, de sorte que les portions latérales comprennent toujours le matériau diélectrique non modifié *stricto sensu.* Dans la présente demande, les portions latérales non modifiées désignent ainsi au moins les portions latérales comprenant le matériau diélectrique non modifié *stricto sensu,* et éventuellement cette couche superficielle faiblement modifiée.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants. Ainsi, une couche à base de silicium s'entend par exemple d'une couche Si, Si dopé n, Si dopé p, SiGe. Une couche à base de germanium s'entend par exemple d'une couche Ge, Ge dopé n, Ge dopé p, SiGe.

Le mot « diélectrique » qualifie un matériau dont la conductivité électrique est suffisamment faible dans l'application donnée pour servir d'isolant. Dans la présente invention, un matériau diélectrique présente de préférence une constante diélectrique inférieure à 7. Le matériau diélectrique modifié est réputé différent du matériau diélectrique non modifié.

En général, mais non limitativement, un espaceur forme une bague autour de la grille, avec un contour fermé ; on pourrait donc parler d'un espaceur unique autour de la grille; cependant, les représentations en coupe, et les directions privilégiées des grilles, font que l'on parle aussi de paires d'espaceurs (ou premier et deuxième espaceurs), terminologie ici retenue.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy. Le terme « latéral » se réfère à un plan xz. Ainsi, les flancs latéraux de la grille s'étendent parallèlement à un plan xz.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

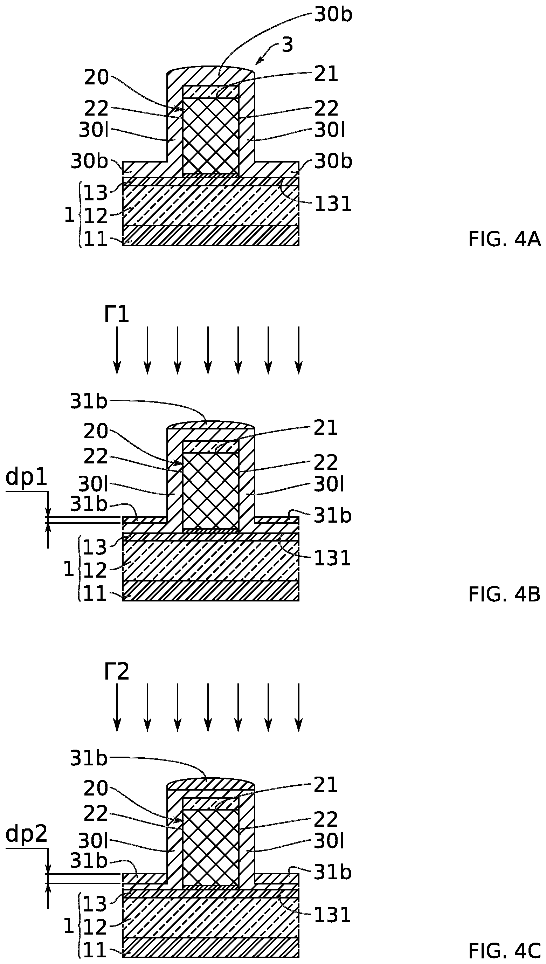

Les figures 4A à 4E illustrent un mode de réalisation du procédé selon l'invention. Selon ce mode de réalisation, une structure initiale illustrée en figure 4A est fournie.

Cette structure peut typiquement comprendre un substrat 1 comprenant une couche active 13 semiconductrice à base de silicium ou de germanium. Cette couche active 13 présente typiquement une épaisseur de l'ordre de quelques nanomètres, par exemple 6 nm à 8 nm.

Le substrat 1 peut comprendre un support 11 massif dit « bulk », surmonté par une couche 12 isolante électriquement, typiquement une couche d'oxyde dite « BOX ».

Le support 11, la couche isolante 12 et la couche active 13 peuvent former un substrat 1 de type semiconducteur sur isolant, par exemple un substrat silicium sur isolant SOI (acronyme de l'anglais « silicon on insulator) ou un substrat germanium sur isolant GeOI (acronyme de l'anglais « germanium on insulator), ou encore un substrat silicium sur isolant complètement déserté FDSOI (acronyme de l'anglais « fully depleted silicon on insulator).

La couche active 13 est surmontée d'un motif de grille ou grille 20.

De manière classique, ce motif de grille 20 peut présenter successivement les éléments suivants disposés à partir de la couche active 13 : une couche d'oxyde d'interface ou une couche d'oxyde d'hafnium présentant une haute constante diélectrique, dite high k, une grille polysilicium et un masque dur.

Le motif de grille 20 présente typiquement une hauteur selon Z de plusieurs dizaines de nanomètres à plusieurs centaines de nanomètres.

Dans la suite de la description, et par souci de concision, le motif de grille sera désigné par la suite grille 20.

Comme illustré à la figure 4A, une couche diélectrique 3 en un matériau diélectrique, par exemple en nitrure de silicium, recouvre la grille 20 et la couche active 13 semi conductrice. L'épaisseur eb de cette couche diélectrique 3 est de préférence sensiblement constante. Elle peut être comprise entre 5 nm et 20 nm, de préférence entre 7 nm et 12 nm.

Cette couche diélectrique 3 comprend une portion latérale 30l sur chacun des flancs latéraux 22 de la grille 20, des portions basales 30b en surface du substrat 1 de part et d'autre de la grille 20, au contact de la couche active 13, et une portion basale 30b au sommet 21 de la grille 20. Les portions latérales 30l s'étendent selon des plans perpendiculaires au plan XY et les portions basales 30b s'étendent selon des plans parallèles au plan XY.

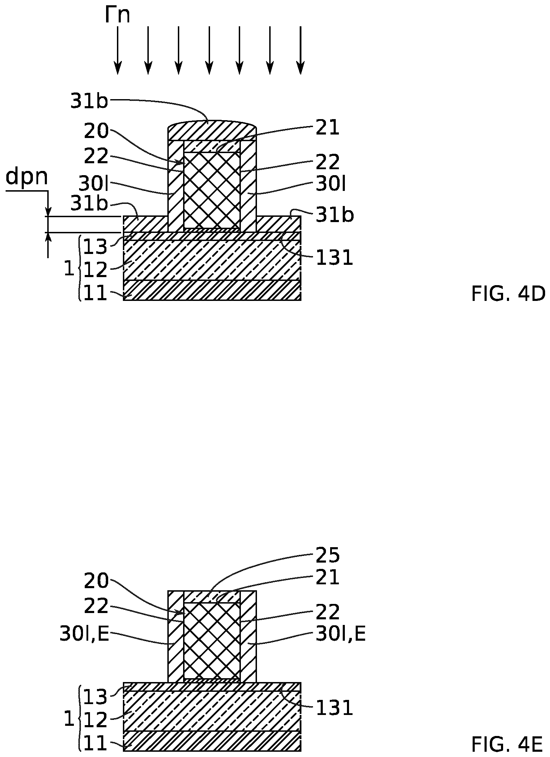

Les figures 4B à 4D illustrent la modification anisotrope des portions basales 30b de la couche diélectrique 3, par phases d'implantation successives selon Z. La figure 4E illustre le retrait des portions basales modifiées 31b, après la succession des différentes phases d'implantation.

Comme illustré à la figure 4B, une première phase d'implantation est effectuée à une énergie d'implantation Γ1. Cette première phase d'implantation permet de modifier les portions basales 30b sur une profondeur dp1. Des portions basales modifiées 31b d'épaisseur dp1 sont ainsi obtenues.

En revanche, cette première phase ne modifie pas les portions latérales 30l situées sur les flancs 22 de la grille 20, ces portions latérales 30l étant masquées par la portion basale 30B située au sommet 21 de la grille 20.

Une deuxième phase d'implantation est ensuite effectuée à une énergie d'implantation Γ2 ≠ Γ1 (figure 4C). Cette deuxième phase d'implantation permet de modifier les portions basales 30b sur une profondeur dp2. Des portions basales modifiées 31b d'épaisseur dp2 sont ainsi obtenues. Cette deuxième phase ne modifie pas les portions latérales 30l situées sur les flancs 22 de la grille 20.

Une n-ième phase d'implantation est ensuite effectuée à une énergie d'implantation Γn ≠ Γ1, Γ2 (figure 4D). Cette n-ième phase d'implantation permet de modifier les portions basales 30b sur une profondeur dpn. Des portions basales modifiées 31b d'épaisseur dpn sont ainsi obtenues. Cette n-ième phase ne modifie pas les portions latérales 30l situées sur les flancs 22 de la grille 20.

Avantageusement, l'ensemble des n phases d'implantation est configuré de manière à ce que l'épaisseur dpn des portions basales modifiées 31b soit égale à l'épaisseur eb de la couche diélectrique.

Le nombre n de phases d'implantation est de préférence supérieur ou égal à 3. On choisira ainsi de préférence au moins une phase d'implantation à basse énergie, par exemple à une énergie d'implantation de l'ordre de 20eV, au moins une phase d'implantation intermédiaire, par exemple à une énergie d'implantation de l'ordre de 100eV à 150 eV, et au moins une phase d'implantation à haute énergie, par exemple à une énergie d'implantation de l'ordre de 200eV à 300eV.

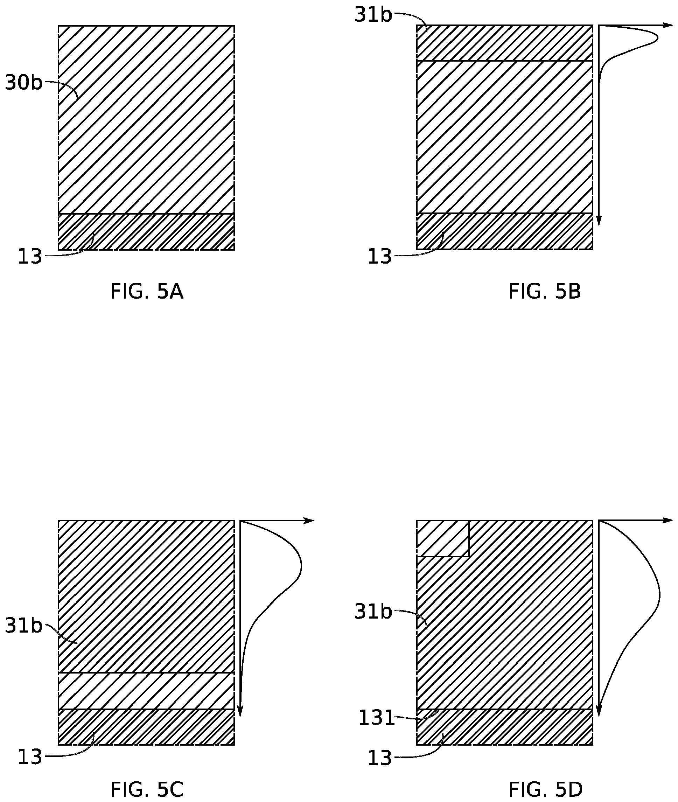

Les figures 5A à 5D illustrent plus précisément ce qui se passe au niveau de la portion basale 30b lors des différentes phases d'implantation. La phase d'implantation à basse énergie permet typiquement de modifier les premiers nanomètres de la couche diélectrique (figure 5B). Le profil d'implantation de cette phase d'implantation à basse énergie présente une queue de distribution qui va contribuer à augmenter la concentration d'espèces implantées plus profondément, lors des phases d'implantation à plus haute énergie (figures 5C, 5D). Les profils d'implantation de chaque phase d'implantation vont typiquement s'ajouter pour former un profil d'implantation final plus abrupt au niveau de l'interface entre les portions basales modifiées de la couche diélectrique et la couche active 13. Cela améliore l'homogénéité de la concentration totale Htot en ions légers le long de l'épaisseur eb des portions basales modifiées 31b.

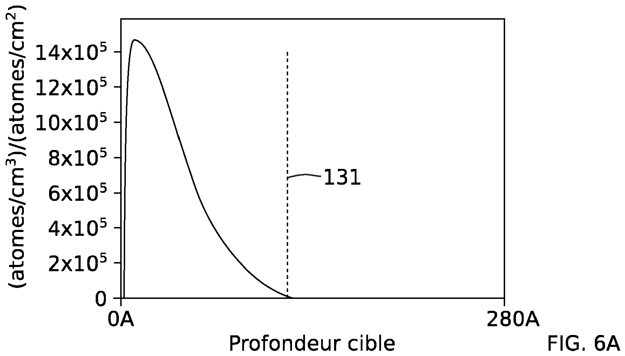

La figure 6A présente un profil d'implantation simulé à partir de phases d'implantation successives d'hydrogène H dans du Si3N4, pour des énergies d'implantation entre 20eV et 300eV par pas de 20eV. La dose totale d'ions légers est tracée en fonction de la profondeur d'implantation, dans une couche diélectrique de Si3N4 d'épaisseur eb = 12nm sur du silicium. Le nombre cumulé d'ions légers implantés est de 15000.

Ce profil d'implantation en plusieurs phases d'implantation successives peut être directement comparé au profil d'implantation de la figure 3, simulé pour une seule implantation d'énergie 300 eV, toutes choses étant égales par ailleurs (même nombre total d'ions légers implantés : 15000, même épaisseur de Si3N4 : 12 nm). Il apparaît que dans le cas des phases d'implantations multiples à différentes énergies, les ions légers implantés sont quasiment absents dans la couche de silicium sous-jacente à la couche de Si3N4. La queue de distribution des ions légers implantés reste dans la couche de Si3N4, à gauche de l'interface 131 sur la figure 6A.

Les conditions d'implantation liées aux différentes phases d'implantation peuvent être déterminées par simulation à l'aide d'un outil de simulation de type SRIM (stopping and range of ions matter) ou TRIM (transport simulation of ions in matter).

Une telle simulation permet par exemple de définir les valeurs maximales et minimales des énergies Γi et le pas Δ en énergie afin de contrôler la queue de distribution des ions légers implantés vis-à-vis de l'interface entre la couche diélectrique et la couche active. Les différentes énergies des phases d'implantation sont idéalement choisies de façon à éviter une modification de la couche active.

L'énergie d'implantation peut varier de façon continue entre deux phases d'implantation successives. Alternativement, l'énergie d'implantation peut varier de façon discontinue entre deux phases d'implantation successives. Elle peut par exemple prendre uniquement des valeurs discrètes, ou uniquement des valeurs continues, ou encore un mélange de valeurs discrètes et continues lors des différentes phases d'implantation successives.

Un autre paramètre influant sur la dose totale d'ions légers implantés est la durée pendant laquelle l'énergie d'implantation est maintenue durant chaque phase d'implantation.

Pour chaque phase d'implantation, l'énergie d'implantation est de préférence maintenue à la valeur $\Gamma i$ pendant quelques secondes, par exemple pendant au moins 2s ou au moins 5s. Des paliers en énergie $\Gamma i$ de durée ti sont ainsi effectués lors des phases d'implantation successives. Ces paliers peuvent présenter tous la même durée, ou des durées différentes. Ils peuvent être atteints par variation continue d'énergie d'un palier à un autre, selon une rampe d'énergie, ou de façon discontinue, par saut d'énergie entre paliers.

La durée totale T de la modification anisotrope correspond ainsi à la somme des durées des paliers ti, ou à la somme des durées des paliers ti et à la somme des durées des rampes d'énergie entre paliers.

La durée totale T et les durées ti des phases d'implantation sont ajustées de façon à contrôler la dose totale implantée dans les portions basales en matériau diélectrique. La durée totale T de la modification anisotrope peut être d'environ 60s pour modifier une épaisseur de nitrure de silicium de 12nm. Cette durée totale peut être réduite en fonction du résultat obtenu, notamment si la consommation de couche active est supérieure à 1nm à l'issue du procédé de formation des espaceurs.

Chaque phase d'implantation est effectuée à partir d'un plasma.

On pourra utiliser un réacteur plasma à couplage capacitif (CCP) ou un réacteur plasma à couplage inductif (ICP), ou un plasma par immersion.

Les paramètres supplémentaires suivants peuvent être réglés pour chaque phase d'implantation par plasma :

- la pression régnant à l'intérieur de la chambre du réacteur plasma. De préférence, cette pression est comprise entre 5 milliTorr et 100 milliTorr, ceci afin d'éviter une implantation isotrope ;
- la température est de préférence inférieure à 100°C, afin de modifier efficacement la couche diélectrique 3 ;
- La tension de polarisation du plasma varie typiquement entre 20V et 300V ;
- la puissance de la source plasma peut être réglée de façon à obtenir un flux ionique plus ou moins important. On choisira typiquement une puissance source comprise entre 100W et 1000W.
- la source plasma peut être radiofréquence (RF), avec une fréquence comprise entre 100 Hz à 5 kHz. On choisira typiquement un rapport cyclique de 10% à 90% pour réduire l'énergie ionique.

On effectuera de préférence l'ensemble des phases d'implantation de la modification anisotrope dans le même équipement, afin de simplifier le procédé et de réduire les couts.

Selon un mode de réalisation, le plasma utilisé est formé à partir d'un gaz comprenant au moins un premier composant gazeux hydrogéné noté H non carboné dont la dissociation génère lesdits ions légers et un deuxième composant gazeux X comprenant au moins une espèce favorisant la dissociation du premier composant H pour former lesdits ions légers, dans lequel le ratio de gaz entre le premier composant et le deuxième composant est compris entre 1 :19 et 19 :1. De préférence ledit ratio est compris entre 1 :9 et 9 :1 et de préférence entre 1 :5 et 5 :1.

Le premier composant H est de préférence choisi parmi le dihydrogène (H2), le silane (SiH4), le nitrure d'hydrogène (NH3) ou le bromure d'hydrogène (HBr). Le deuxième composant X est de préférence choisi parmi l'hélium (He), le diazote (N2), l'argon (Ar) ou le xénon (Xe).

De préférence le débit du premier composant Hest compris entre 10 et 100 sccm (centimètre cube par minute) et le débit du deuxième composant X est de préférence compris entre 10 et 500 sccm.

L'ajout d'un deuxième composant agissant avantageusement comme un gaz de dissociation (tel que l'argon, l'hélium, le xénon, l'azote), permet de faciliter la dissociation du premier composant et par ce biais, de favoriser l'implantation dudit premier composant dissocié dans la couche diélectrique, sous forme d'ions légers. La dose implantée est donc plus élevée sans pour autant avoir besoin d'augmenter la profondeur maximale d'implantation.

Il est donc important de trouver un juste ratio entre la teneur en premier composant et en deuxième composant dans le plasma destiné à modifier la couche diélectrique. Avantageusement, le ratio de gaz entre le premier composant et le deuxième composant est supérieur à 1:19 et inférieur à 19 :1.

Ces phases d'implantation permettent de modifier la couche diélectrique 3 sans pour autant la pulvériser. Ainsi, il s'agit essentiellement d'une modification chimique, l'ajout d'ions dans cette couche 3 changeant la sélectivité à la gravure de cette couche 3. Ainsi, les portions basales modifiées 30b de cette couche 3 se graveront beaucoup plus facilement que les portions latérales 30l non modifiées, la couche active 13 sous-jacente ainsi que le motif de grille 20.

Selon un mode de réalisation, la modification anisotrope comprend 6 phases d'implantation pour modifier 12nm de nitrure de silicium par gravure ICP à base d'un premier composant H = H2 et d'un deuxième composant X = He.

La première phase d'implantation d'énergie $\Gamma 1$ est typiquement effectuée avec les paramètres suivants : Pression = 10 mtorr / Tension RF de polarisation = 50 V / durée t1 =10s / débit X = 250 sccm / débit H2 = 50 sccm / Puissance RF = 500W.

La deuxième phase d'implantation d'énergie $\Gamma 2$ est typiquement effectuée avec les paramètres suivants : Pression = 10 mtorr / Tension RF de polarisation = 100 V / durée t2 =10s / débit X = 250 sccm / débit H2 = 50 sccm / Puissance RF = 500W.

La troisième phase d'implantation d'énergie $\Gamma 3$ est typiquement effectuée avec les paramètres suivants :

Pression = 10 mtorr / Tension RF de polarisation = 150 V / durée t3=10s / débit X = 250 sccm / débit H2 = 50 sccm / Puissance RF = 500W.

La quatrième phase d'implantation d'énergie $\Gamma 4$ est typiquement effectuée avec les paramètres suivants : Pression = 10 mtorr / Tension RF de polarisation = 200 V / durée t4=10s / débit X = 250 sccm / débit H2 = 50 sccm / Puissance RF = 500W.

La cinquième phase d'implantation d'énergie $\Gamma 5$ est typiquement effectuée avec les paramètres suivants : Pression = 10 mtorr / Tension RF de polarisation = 250 V / durée t5=10s / débit X = 250 sccm / débit H2 = 50 sccm / Puissance RF = 500W.

La sixième phase d'implantation d'énergie $\Gamma 6$ est typiquement effectuée avec les paramètres suivants : Pression = 10 mtorr / Tension RF de polarisation = 300 V / durée t6=10s / débit X = 250 sccm / débit H2 = 50 sccm / Puissance RF = 500W.

La durée totale de la modification anisotrope est ainsi de $ttot = \sum_{i=1}^{6} t_i = 60s$.

Ces paramètres peuvent être ajustés en fonction de la nature des portions basales à graver et de l'épaisseur eb.

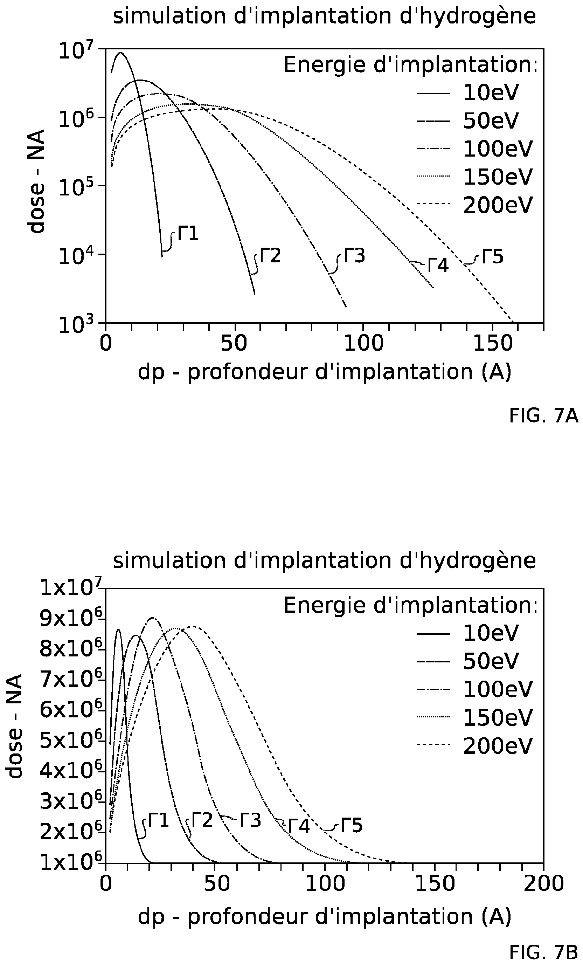

Les figures 7A, 7B illustrent les doses d'hydrogène implanté dans du nitrure de silicium selon la profondeur d'implantation dp, obtenues par simulation via le logiciel SRIM pour des phases d'implantation d'énergies $\Gamma 1$=10eV, $\Gamma 2$=50eV, $\Gamma 3$=100eV, F4=150eV, $\Gamma 5$=200eV.

La forme de la distribution totale d'implantation des atomes d'hydrogène va ainsi profiter des distributions successives de basse énergie $\Gamma 1$, d'énergies intermédiaires $\Gamma 2$, $\Gamma 3$, $\Gamma 4$ et de haute énergie $\Gamma 5$.

En particulier, une phase d'implantation à basse énergie peut compenser un déficit dans la distribution d'ions implantés à haute énergie. Des phases d'implantation successives permettent ainsi de lisser la distribution totale d'ions implantés le long de la profondeur des portions basales modifiées.

Cela permet d'obtenir une modification des couches basales de nitrure de silicium, plus uniforme et sur une plus grande épaisseur, tout en diminuant l'impact de la modification sur le silicium sous-jacent.

Une modification plus uniforme sur l'épaisseur eb des portions basales modifiées permet d'obtenir une vitesse de gravure plus constante lors du retrait sélectif des portions basales modifiées. Cela diminue également les risques d'endommagement de la couche active sous-jacente.

Le retrait sélectif des portions basales modifiées peut être effectué par gravure selon plusieurs variantes de réalisation. Des chimies de gravure sèches ou humides peuvent être utilisées.

Selon un mode de réalisation, le retrait des portions basales modifiées 31b est effectué par gravure humide sélective au matériau semi-conducteur de la couche active 13. Si le matériau semi-conducteur est du silicium, alors le retrait des portions 31b modifiées est effectué par gravure humide sélectivement au silicium (Si).

De préférence, la gravure sélective au silicium est obtenue à l'aide d'une solution à base d'acide fluorhydrique (HF) ou à l'aide d'une solution à base d'acide phosphorique (H3PO4). Par exemple, pour éliminer 15 nm de nitrure de silicium modifié, une solution HF 1% pendant 60s ou une solution H3PO4 pendant 45s peuvent être utilisées.

A titre d'exemple pour une couche diélectrique 3 en SiN, avec une solution à base d'acide fluorhydrique (HF), le rapport de vitesse de gravure entre SiN modifié et SiN est de l'ordre de 30; à titre d'exemple, le rapport de vitesse de gravure entre SiN modifié et SiO2 est de l'ordre de 38.

Cela permet de retirer entièrement les portions 31b modifiées sans consommer les portions latérales 30l non modifiées sur les flancs 22 de la grille 20, ni consommer la couche active 13.

Les performances des transistors sont ainsi préservées.

Selon un mode de réalisation, particulièrement avantageux lorsque la couche diélectrique 3 est en un matériau pris parmi : un nitrure de silicium, SiC, SiCN, SiCBN, la gravure sélective des portions basales modifiées 31b vis-à-vis des portions latérales 30l non modifiées comprend une gravure humide à base d'une solution comprenant de l'acide fluorhydrique (HF) diluée à x% en masse, avec x≤02 et présentant un pH inférieur ou égal à 1,5. De préférence, le pH est inférieur ou égal à 1,3, plus préférentiellement inférieur ou égal à 1 et de préférence strictement inférieur à 1. Le facteur de dilution x est de préférence inférieur ou égal à 0,15, de préférence x ≤ 0,1. Selon un exemple, x est sensiblement égal à 0,1.

Une telle solution de gravure peut être obtenue par ajout d'au moins l'un parmi : acide chlorhydrique (HCl), acide sulfurique H2SO4, acide nitrique HNO3.

De manière particulièrement surprenante cette gravure permet d'augmenter significativement la sélectivité de la gravure du matériau diélectrique modifié vis-à-vis des matériaux à base d'oxyde de silicium, désigné de manière générale SiOy dans la présente demande de brevet, avec y entier supérieur ou égal à 1.

Par exemple, avec le procédé selon l'invention, on obtient une sélectivité de la gravure par rapport au dioxyde de silicium telle que pour une épaisseur e1 de nitrure modifié gravée, on ne grave dans le même temps qu'une épaisseur e1/33.7 de dioxyde de silicium. Cette sélectivité améliorée est très avantageuse puisque bien souvent un masque dur 25 sur le sommet 21 de la grille 20 ou une tranchée d'isolation, à base de SiOy, sont présents lors de l'étape de gravure (figure 4E).

Il s'ensuit que le masque dur ou les tranchées d'isolation ne sont pas altérés par la gravure des espaceurs E. Ils peuvent donc pleinement jouer leurs rôles respectifs.

Selon un autre mode de réalisation, le retrait des portions basales modifiées est effectué par gravure sèche sélective au matériau semiconducteur. De préférence, le retrait des portions 31b modifiées, typiquement en nitrure de silicium, est effectuée par gravure sèche sélective au silicium (Si) et/ou à l'oxyde de silicium (SiO2). Par exemple, pour éliminer 15 nm de nitrure modifié, une chimie de gravure sèche à base d'espèces hydrofluorocarbonées et de tétrachlorure de silicium (SiCl4) pendant environ 30s peut être utilisée.

Selon un autre mode de réalisation, la gravure sèche est effectuée dans un plasma formé dans une enceinte confinée à partir de trifluorure d'azote (NF3) et d'ammoniac (NH3).

Avantageusement, la gravure sèche comprend : une étape de gravure consistant en la formation de sels solides, suivie d'une étape de sublimation des sels solides. Ce mode de réalisation permet d'obtenir une très bonne sélectivité de la gravure du nitrure modifié par rapport au nitrure non modifié et au matériau semiconducteur. En particulier, cette sélectivité de la gravure est très supérieure (typiquement un facteur 10 au moins) à celle obtenue avec une solution de HF.

Selon un autre mode de réalisation, l'étape de retrait des portions 31b modifiées vis-à-vis des portions 30l non modifiées comprend une gravure sèche réalisée par mise en présence d'un mélange gazeux, de préférence uniquement gazeux, comprenant au moins un premier composant à base d'acide fluorhydrique (HF). L'acide fluorhydrique transforme en résidus non-volatiles, de préférence non-volatiles à température ambiante, les portions 31b modifiées de la couche diélectrique 3.

Avantageusement, l'étape de retrait des portions 31b comprend, uniquement après la gravure sèche, un retrait des résidus non-volatiles à température ambiante par un nettoyage humide ou un recuit thermique de sublimation.

Avantageusement, la gravure sèche consomme les portions basales 31b modifiées de la couche diélectrique 3 préférentiellement aux portions latérales 30l non modifiées et à la couche active 13. Ainsi, le risque de consommation excessive de matériau semi-conducteur en surface de la couche active 13 est réduit, voire supprimé.

Après retrait des portions basales 31b modifiées, les espaceurs E sont typiquement formés par les portions latérales 30l non modifiées (figure 4E). Le procédé permet avantageusement de réaliser des espaceurs E pour des transistors MOSFET.

L'invention n'est pas limitée aux modes de réalisations précédemment décrits et s'étend à tous les modes de réalisation couverts par les revendications.

Par exemple, il est possible d'augmenter ou de diminuer la puissance source pour modifier la densité d'ions créés. Le flux ionique d'incorporation d'ions légers dans les portions basales peut ainsi être ajusté.

Par exemple, il est possible d'augmenter ou de diminuer la durée des phases d'implantation pour une durée totale constante.

Par exemple, il est possible d'augmenter ou de diminuer le nombre de phases d'implantation.

Par exemple, il est possible d'augmenter ou de diminuer l'énergie des phases d'implantation.

Selon un exemple, il est possible de pulser l'énergie d'implantation des ions légers lors des phases d'implantation.

Le procédé peut être avantageusement appliqué à la réalisation d'espaceurs pour des transistors à architecture 3D de type nanofil.

## Revendications

1.   Procédé de formation des espaceurs (E) d'une grille (20) d'un transistor située sur une couche active (13) en un matériau semi-conducteur, comprenant :

• Une fourniture d'un empilement comprenant la couche active (13) et la grille (20), ladite grille (20) présentant un sommet (21) et des flancs latéraux (22),
• une formation d'une couche diélectrique (3) en un matériau diélectrique recouvrant la grille et au moins partiellement la couche active (13) de part et d'autre de la grille (20), ladite couche diélectrique (3) présentant des portions latérales (30l) recouvrant les flancs latéraux (22) de la grille, et des portions basales (30b) recouvrant le sommet (21) et la couche active (13), les portions basales (30b) présentant une épaisseur eb,
• une modification anisotrope des portions basales (30b) de ladite couche diélectrique (3) par implantation d'ions légers selon une direction (Z) parallèle aux flancs latéraux (22) de la grille (20), formant des portions basales (31b) modifiées à base du matériau diélectrique modifié et des portions latérales (30l) non modifiées à base du matériau diélectrique non modifié,
• un retrait des portions basales (31b) modifiées par gravure sélective du matériau diélectrique modifié vis-à-vis du matériau diélectrique non modifié et vis-à-vis du matériau semi-conducteur, de façon à former les espaceurs (E) sur les flancs latéraux (22) de la grille à partir des portions latérales (30l) non modifiées,

le procédé étant **caractérisé en ce que** :

• avant le retrait, la modification anisotrope des portions basales (30b) comprend n phases d'implantation successives présentant des énergies d'implantation $\Gamma_i$ (i=1 ... n) des ions légers distinctes les unes des autres, $n \geq 3$, lesdites n phases étant configurées pour implanter les ions légers à différentes profondeurs nominales d'implantation $dp_i$ (i=1 ... n) dans les portions basales (30b)

• chaque phase d'implantation est effectuée à partir d'un plasma.

2. Procédé selon la revendication précédente dans lequel les n phases d'implantation successives sont configurées pour modifier les portions basales (30b) selon toute l'épaisseur eb.

3. Procédé selon l'une quelconque des revendications précédentes dans lequel les n phases d'implantation sont configurées de sorte à ce que les portions basales (31b) modifiées présentent après modification une variation de concentration totale en ions légers [H]tot inférieure à 20% le long de l'épaisseur eb.

4. Procédé selon l'une quelconque des revendications précédentes dans lequel le nombre de phases d'implantations n est égal à 3 et les énergies d'implantation $\Gamma 1$, $\Gamma 2$, $\Gamma 3$ sont telles que $\Gamma 1 \leq 0,5.\Gamma 2$ et $\Gamma 2 \leq 0,6.\Gamma 3$.

5. Procédé selon l'une quelconque des revendications précédentes dans lequel chaque phase d'implantation est configurée pour implanter des ions légers à une concentration [H]i(dpi) maximale à la profondeur nominale d'implantation dpi, et dans lequel les profondeurs nominales d'implantation sont choisies telles que dpi = eb.i/(i+1).

6. Procédé selon l'une quelconque des revendications précédentes dans lequel l'implantation anisotrope est effectuée par plasma à couplage inductif ou à couplage capacitif, à base d'espèces formant les ions légers, les ions légers étant des ions à base d'hydrogène (H).

7. Procédé selon la revendication précédente dans lequel le plasma est formé à partir de dihydrogène (H2) et d'au moins une espèce X favorisant la dissociation du dihydrogène pour former lesdits ions légers, ladite au moins une espèce X étant prise parmi l'argon, l'azote, le xénon, l'hélium.

8. Procédé selon l'une quelconque des revendications précédentes dans lequel chaque énergie d'implantation $\Gamma i$ (i=1... n) est maintenue durant une durée ti $\geq 5$ s, de sorte à ce que les phases d'implantation successives forment des paliers de durée ti et d'énergie d'implantation $\Gamma i$ (i=1... n).

9. Procédé selon l'une quelconque des revendications précédentes dans lequel les énergies d'implantation $\Gamma i$ (i=1... n) sont telles que $\Gamma i+1 = \Gamma i + \Delta$, avec $\Delta$ un pas en énergie tel que $\Delta \geq 30$ eV, de préférence $\Delta \geq 50$ eV.

10. Procédé selon l'une quelconque des revendications 1 à 8 dans lequel les énergies d'implantation $\Gamma i$ (i=1... n) varient de façon continue et monotone entre $\Gamma 1$ et $\Gamma n$ lors de la modification anisotrope.

11. Procédé selon l'une quelconque des revendications précédentes dans lequel les n phases d'implantations sont configurées pour durer chacune une durée ti (i=1... n) $\geq$ T/2(n+1), où T est une durée totale de la modification anisotrope.

12. Procédé selon l'une quelconque des revendications précédentes dans lequel les énergies d'implantation $\Gamma i$ (i=1... n) sont comprises entre 20 eV et 300 eV.

13. Procédé selon l'une quelconque des revendications précédentes dans lequel les phases d'implantation sont effectuées par ordre d'énergie d'implantation croissant.

14. Procédé selon l'une quelconque des revendications précédentes dans lequel les phases d'implantation successives présentent une variation d'énergie d'implantation supérieure ou égale à 20%, tel que $0,8.\Gamma i-1 \leq \Gamma i \leq 1,2.\Gamma i+1$ avec i=1...n.

15. Procédé selon l'une quelconque des revendications précédentes dans lequel le nombre de phases d'implantations n est égal à 6 et les énergies d'implantation sont telles que $\Gamma 1 = 50eV$, $\Gamma 2 = 100eV$, $\Gamma 3 = 150eV$, $\Gamma 4 = 200eV$, $\Gamma 5 = 250eV$, $\Gamma 6 = 300eV$, chaque phase d'implantation étant effectuée pendant une durée ti (i=1...6) comprise entre 2s et 20s.

**Patentansprüche**

1. Verfahren zum Bilden von Abstandshaltern (E) eines Gates (20) eines Transistors, das sich auf einer aktiven Schicht (13) aus einem Halbleitermaterial befindet, umfassend:

   • eine Bereitstellung eines Stapels, der die aktive Schicht (13) und das Gate (20) umfasst, wobei das Gate (20) eine Oberseite (21) und seitliche Flanken (22) aufweist,
   • eine Bildung einer dielektrischen Schicht (3) aus einem dielektrischen Material, die das Gate und mindestens teilweise die aktive Schicht (13) auf beiden Seiten des Gates (20) bedeckt, wobei die dielektrische Schicht (3) seitliche Abschnitte (301) aufweist, die die seitlichen Flanken (22) des Gates bedecken, und basale Abschnitte (30b), die die Oberseite (21) und die aktive Schicht (13) bedecken, wobei die basalen Abschnitte (30b) eine Dicke eb aufweisen,
   • eine anisotrope Modifikation der basalen Abschnitte (30b) der dielektrischen Schicht (3) durch Implantation von leichten Ionen in einer Richtung (Z) parallel zu den seitlichen Flanken (22) des Gates (20), wodurch modifizierte basale Abschnitte (31b) auf der Basis des modifizierten dielektrischen Materials und der nicht-modifizierten seitlichen Abschnitte (301) auf der Basis des nicht-modifizierten dielektrischen Materials gebildet werden,

• eine Entfernung der modifizierten basalen Abschnitte (31b) durch selektives Ätzen des modifizierten dielektrischen Materials gegenüber dem nicht-modifizierten dielektrischen Material und gegenüber dem Halbleitermaterial, um die Abstandshalter (E) an den seitlichen Flanken (22) des Gates zu bilden, ausgehend von den nicht-modifizierten seitlichen Abschnitten (301), wobei das Verfahren **dadurch gekennzeichnet ist, dass**:

• vor der Entfernung, die anisotrope Modifikation der basalen Abschnitte (30b) n aufeinanderfolgende Implantationsphasen umfasst, die Implantationsenergien $\Gamma$ i (i=1...n) von leichten Ionen aufweisen, die voneinander verschieden sind, $n \geq 3$, wobei die n Phasen konfiguriert sind, um die leichten Ionen in verschiedenen nominalen Implantationstiefen dpi (i=1...n) in den basalen Abschnitten (30b) zu implantieren,

• jede Implantationsphase wird ausgehend von einem Plasma durchgeführt.

2. Verfahren nach dem vorhergehenden Anspruch, wobei die n aufeinanderfolgenden Implantationsphasen konfiguriert sind, um die basalen Abschnitte (30b) entlang der gesamten Dicke eb zu modifizieren.

3. Verfahren nach einem der vorhergehenden Ansprüche, wobei die n Implantationsphasen so konfiguriert sind, dass die modifizierten basalen Abschnitte (31b) nach der Modifikation eine Variation der gesamten Konzentration an leichten Ionen [H]tot von weniger als 20 % entlang der Dicke eb aufweisen.

4. Verfahren nach einem der vorhergehenden Ansprüche, wobei die Anzahl der Implantationsphasen n gleich 3 ist und die Implantationsenergien $\Gamma$ 1, $\Gamma$ 2, $\Gamma$ 3 so sind, dass $\Gamma$ $1 \leq 0,5.$ $\Gamma$ 2 und $\Gamma$ $2 \leq 0,6.$ $\Gamma$ 3.

5. Verfahren nach einem der vorhergehenden Ansprüche, wobei jede Implantationsphase konfiguriert ist, um leichte Ionen bei einer maximalen Konzentration [H]i(dpi) bei der nominalen implantationstiefe dpi zu implantieren, und wobei die nominalen Implantationstiefen so gewählt sind, dass dpi = eb.i/(i+1).

6. Verfahren nach einem der vorhergehenden Ansprüche, wobei die anisotrope Implantation durch induktiv gekoppeltes oder kapazitiv gekoppeltes Plasma auf der Basis von Spezies durchgeführt wird, die die leichten Ionen bilden, wobei die leichten Ionen Ionen auf der Basis von Wasserstoff (H) sind.

7. Verfahren nach dem vorhergehenden Anspruch, wobei das Plasma aus Dihydrogen (H2) gebildet wird und mindestens einer Spezies X, die die Dissoziation des Dihydrogens begünstigt, um die leichten Ionen zu bilden, wobei die mindestens eine Spezies X aus Argon, Stickstoff, Xenon und Helium ausgewählt wird.

8. Verfahren nach einem der vorhergehenden Ansprüche, wobei jede Implantationsenergie $\Gamma$ i (i=1...N) für eine Dauer ti $\geq 5$ s gehalten wird, so dass aufeinanderfolgende Implantationsphasen Plateaus mit der Dauer ti und der Implantationsenergie $\Gamma$ i (i=1...n) bilden.

9. Verfahren nach einem der vorhergehenden Ansprüche, wobei die Implantationsenergien $\Gamma$ i (i=1...n) so sind, dass $\Gamma$ i+1 = $\Gamma$ i + $\Delta$, mit $\Delta$ einem Schritt aus Energie, so dass $\Delta \geq 30$ eV, vorzugsweise $\Delta \geq 50$ eV.

10. Verfahren nach einem der Ansprüche 1 bis 8, wobei die Implantationsenergien ri (i=1...n) kontinuierlich und monoton zwischen $\Gamma$ 1 und $\Gamma$ n variieren, während der anisotropen Modifikation.

11. Verfahren nach einem der vorhergehenden Ansprüche, wobei die n Implantationsphasen konfiguriert sind, um jeweils eine Dauer ti (i=1...n) $\geq$ T/2(n+1) zu dauern, wobei T eine Gesamtdauer der anisotropen Modifikation ist.

12. Verfahren nach einem der vorhergehenden Ansprüche, wobei die Implantationsenergien $\Gamma$ i (i=1...n) zwischen 20 eV und 300 eV liegen.

13. Verfahren nach einem der vorhergehenden Ansprüche, wobei die Implantationsphasen in zunehmender Reihenfolge der Implantationsenergie durchgeführt werden.

14. Verfahren nach einem der vorhergehenden Ansprüche, wobei die aufeinanderfolgenden Implantationsphasen eine Variation der Implantationsenergie größer oder gleich 20 % aufweisen, wie 0,8. ri-1 $\leq$ $\Gamma$ i $\leq$ 1,2 $\Gamma$ i+1 mit 1=...n.

15. Verfahren nach einem der vorhergehenden Ansprüche, wobei die Anzahl der n Implantationsphasen gleich 6 ist und die Implantationsenergien wie $\Gamma$ 1

= 50eV, r2 = 100eV, r3 = 150eV, r4 = 200eV, r5 = 250eV, r6 = 300eV sind, wobei jede Implantationsphase für eine Dauer ti (i=1...6) zwischen 2s und 20s durchgeführt wird.

## Claims

1. A method for forming the spacers (E) of a gate (20) of a transistor located on an active layer (13) of a semiconductor material, comprising:

   • A provision of a stack comprising the active layer (13) and the gate (20), said gate (20) having a top (21) and lateral sides (22),
   • a formation of a dielectric layer (3) from a dielectric material covering the gate and at least partially the active layer (13) on either side of the gate (20), said dielectric layer (3) having lateral portions (301) covering the lateral sides (22) of the gate, and basal portions (30b) covering the top (21) and the active layer (13), the basal portions (30b) having a thickness eb,
   • an anisotropic modification of the basal portions (30b) of said dielectric layer (3) by implantation of light ions in a direction (Z) parallel to the lateral sides (22) of the gate (20), forming modified basal portions (31b) based on the modified dielectric material and the unmodified lateral portions (301) based on the unmodified dielectric material,
   • removal of the modified basal portions (31b) by selective etching of the modified dielectric material with respect to the unmodified dielectric material and with respect to the semiconductor material, so as to form the spacers (E) on the lateral sides (22) of the gate from the unmodified lateral portions (301),

   the method being **characterised in that**:

   • before removal, the anisotropic modification of the basal portions (30b) comprises n successive implantation phases having implantation energies $\Gamma_i$ (i=1...n) of light ions distinct from each other, n ≥ 3, said n phases being configured to implant the light ions at different nominal implantation depths dpi (i=1...n) in the basal portions (30b)
   • each implantation phase is carried out using plasma.

2. The method according to the preceding claim wherein the n successive implantation phases are configured to modify the basal portions (30b) along the entire thickness eb.

3. The method according to any one of the preceding claims wherein the n implantation phases are configured so that the modified basal portions (31b) have after modification a variation in total concentration of light ions [H]tot lower than 20% along the thickness eb.

4. The method according to any one of the preceding claims wherein the number of implantation phases n is equal to 3 and the implantation energies $\Gamma 1$, $\Gamma 2$, $\Gamma 3$ are such that $\Gamma 1 \leq 0.5.\Gamma 2$ and $\Gamma 2 \leq 0.6.\Gamma 3$.

5. The method according to any one of the preceding claims wherein each implantation phase is configured to implant light ions at a maximum concentration [H]i(dpi) at the nominal implantation depth dpi, and wherein the nominal implementation depths are chosen such that dpi = eb.i/(i+1).

6. The method according to any one of the preceding claims wherein the anisotropic implantation is carried out by inductively coupled or capacitively coupled plasma, based on species forming the light ions, the light ions being hydrogen-based ions (H).

7. The method according to the preceding claim wherein the plasma is formed from dihydrogen (H2) and at least one species X promoting the dissociation of dihydrogen to form said light ions, said at least one species X being taken from argon, nitrogen, xenon, helium.

8. The method according to any one of the preceding claims wherein each implantation energy $\Gamma_i$ (i=1...n) is maintained for a duration ti ≥ 5 s, so that the successive implantation phases form levels of duration ti and of implantation energy $\Gamma_i$ (i=1...n).

9. The method according to any one of the preceding claims wherein the implantation energies $\Gamma_i$ (i=1...n) are such that $\Gamma_{i+1} = \Gamma_i + \Delta$, with $\Delta$ an energy step such that $\Delta \geq 30$ eV, preferably $\Delta \geq 50$ eV.

10. The method according to any one of claims 1 to 8 wherein the implantation energies $\Gamma_i$ (i=1...n) vary continuously and monotonically between $\Gamma 1$ and $\Gamma n$ during the anisotropic modification.

11. The method according to any one of the preceding claims wherein the n implementation phases are configured to each last a duration ti (i=1...n) ≥ T/2(n+1), where T is a total duration of the anisotropic modification.

12. The method according to any one of the preceding claims wherein the implantation energies $\Gamma_i$ (i=1...n) are comprised between 20 eV and 300 eV.

13. The method according to any one of the preceding claims wherein the implantation phases are carried out in order of increasing implantation energy.

14. The method according to any one of the preceding claims wherein the successive implantation phases have an implantation energy variation greater than or equal to 20%, such that $0.8.\Gamma i\text{-}1 \leq \Gamma i \leq 1.2.\Gamma i\text{+}1$ with i=1...n.

15. The method according to any one of the preceding claims wherein the number of implantation phases n is equal to 6 and the implantation energies are such that $\Gamma 1 = 50eV$, $\Gamma 2 = 100eV$, $\Gamma 3 = 150eV$, $\Gamma 4 = 200eV$, $\Gamma 5 = 250eV$, $\Gamma 6 = 300eV$, each implantation phase being carried out for a duration ti (i=1... 6) comprised between 2s and 20s.

FIG. 1A

FIG. 1B

FIG. 1C

eb
30b
131
13

FIG. 2A

dp
md
31b
131
13

FIG. 2B

32b
131
13

FIG. 2C

31b
33b
13
md
qd

FIG. 2D

33b
13

FIG. 2E

FIG. 3

30b

3

20

22

30l

30b

21

22

30l

30b

131

13
1 12
11

FIG. 4A

Γ1

31b

20

22

30l

31b

dp1

21

22

30l

31b

131

13
1 12
11

FIG. 4B

Γ2

31b

20

22

30l

31b

dp2

21

22

30l

31b

131

13
1 12
11

FIG. 4C

Γn

31b
20
22
dpn
30l
31b
13
1 12
11
21
22
30l
31b
131

FIG. 4D

25
20
21
22
22
30l,E
30l,E
13
1 12
11
131

FIG. 4E

30b

13

**FIG. 5A**

31b

13

**FIG. 5B**

31b

13

**FIG. 5C**

31b

131

13

**FIG. 5D**

FIG. 6A

FIG. 7A

FIG. 7B

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 671857 A
- EP 3107125 A